(19) Europäisches Patentamt
European Patent Office
Office européen des brevets

(11) **EP 4 063 889 A1**

(12) **EUROPEAN PATENT APPLICATION**

(43) Date of publication:
**28.09.2022 Bulletin 2022/39**

(21) Application number: **21164688.0**

(22) Date of filing: **24.03.2021**

(51) International Patent Classification (IPC):
**G01R 33/30** *(2006.01)*    *G01R 33/46* *(2006.01)*

(52) Cooperative Patent Classification (CPC):
**G01R 33/307**; G01R 33/46

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ETH Zurich**
**8092 Zurich (CH)**

(72) Inventor: **BARNES, Alexander**
**8044 Zürich (CH)**

(54) **ADJUSTMENT OF SAMPLE SPINNING ANGLE IN A MAGNETIC FIELD**

(57)    A stator (1) for a probe (2) of a magnetic resonance spectrometer comprises a receptacle (4) for receiving a rotor (3), wherein the receptacle (4) is configured such, that a rotor (3) being received in the receptacle (4) is rotatable about an axis of rotation (R), and at least one rotation device (5) that is configured to generate a rotation of the rotor (3) being received in the receptacle (4) about the axis of rotation (R). The stator (1) further comprises at least one adjustment device (6) that is configured to generate a force on the rotor (3) being received in the receptacle (4) so as to adjust the axis of rotation (R) of the rotor (3) relative to an adjustment axis (A) of the stator (1).

FIG. 6

**Description**

TECHNICAL FIELD

The present invention relates to a stator as claimed in claim 1, to a rotor being receivable in such a stator as claimed in claim 9, to a probe for a magnetic resonance spectrometer comprising such a stator as claimed in claim 10, to a magnetic resonance spectrometer comprising such a probe or stator as claimed in claim 11, to a method of producing a stator as claimed in claim 12, to a method of adjusting an axis of rotation of a rotor as claimed in claim 13, and to a computer program product that enables to carry out or control such a method as claimed in claim 15, respectively.

PRIOR ART

A necessary part of every solid state Nuclear Magnetic Resonance (NMR) experiment employing the technique of magic-angle spinning (MAS) is the adjustment of an axis of rotation of a rotor, i.e. the rotor's spinning axis, to be aligned with the magic angle, which is 54.73560° with respect to the external magnetic field. Rapidly spinning a solid sample about the magic angle yields a significant increase in resolution by averaging anisotropic spin interactions such as the chemical shift anisotropy, dipolar coupling, and quadrupolar coupling to first order. To date, solid state MAS NMR probes have generally employed a mechanical angle adjustment method for setting the sample to the magic angle, where the linear motion of a threaded rod pitches the stator about an axis perpendicular to the magnetic field. While simple and effective, the mechanical adjustment system can be quite problematic in cryogenic MAS due to thermal contraction, and generally can take up significant volume within the probehead. This extra space is becoming increasingly valuable as more and more solid state NMR probes are being designed to fit within narrow-bore magnets. Moreover, sufficient space within probeheads is also required for RF circuitry elements, microwave components, and cryogenics for dynamic nuclear polarization (DNP) experiments. Additionally, the requirement that the stator and coil must be able to rotate together necessitates that flexible copper leads must be used to link the RF circuit to the coil, which imposes a constraint in RF engineering of probeheads and becomes a significant drawback at high NMR frequencies (>800 MHz) where ideally, lead lengths should be rigid and short.

Thus, current strategies to adjust the angle of sample spinning in NMR all require mechanical mechanisms. These are cumbersome and have disadvantages such as i) they do not function well in cryogenic environments, ii) require flexibility of radio frequency leads on the coil which can lead to metal fatigue, RF loses, and perturbation of the RF circuit during angle adjustment, iii) require the manufacture and installation of many different parts, iv) require an off-axis pivot point which increases the required bore diameter of superconducting magnets, and v) the angle of sample spinning is difficult to change during the experiment.

SUMMARY OF THE INVENTION

It is an object of the present invention to provide a stator for a probe of an NMR spectrometer that overcomes the drawbacks of the prior art. In particular, it is an object of the present invention to provide a stator that allows a precise alignment of a rotor under various conditions, especially under extreme conditions such as cryogenic conditions, and that at the same time has a simple design.

This object is achieved with a stator according to claim 1. In particular, a stator for a probe of a magnetic resonance spectrometer is provided, wherein the stator comprises a receptacle for receiving a rotor, and at least one rotation device. The receptacle is configured such, that a rotor being received in the receptacle is rotatable about an axis of rotation. The rotation device is configured to generate a rotation of the rotor being received in the receptacle about the axis of rotation. The stator further comprises at least one adjustment device that is configured to generate a force on the rotor being received in the receptacle so as to adjust the axis of rotation of the rotor relative to an adjustment axis of the stator.

As mentioned initially, in nuclear magnetic resonance (NMR), the field of the invention, it is well-known that a rotation or spinning of a rotor comprising a sample about the so-called magic angle averages out anisotropic interactions in the sample, whereby a significant increase in resolution of the recorded NMR spectra can be obtained. The magic

$$\Theta_{\mathrm{m}} = \arccos \frac{1}{\sqrt{3}} \approx 54.74°.$$

angle is defined as    The present invention aims at rotating the rotor at the magic angle during NMR measurements. In other words, the axis of rotation of the rotor and the adjustment axis of the stator can be said to enclose an angle, and wherein the present invention aims at matching said angle with the magic angle. Again in other words, the stator according to the invention is configured to adjust a direction of the axis of rotation about which the rotor rotates with respect to the adjustment axis of the stator so as to be aligned with the magic angle.

To this end, said adjustment is achieved with at least one adjustment device that is at least partially comprised in the stator or that is at least partially a part of the stator. Furthermore, the adjustment or movement or shift of the axis of rotation the rotor rotates about, i.e. the rotor's spinning axis, is achieved via the application of a force that is exerted by the stator, in particular by its adjustment device, onto the rotor. Consequently, and as will be explained in greater detail below, the adjustment does not involve moving parts or mechanical parts that push the stator or the rotor. As a result, the stator according to the invention has an improved performance especially under extreme conditions. Since it is constituted by fewer parts, it is easier to manufacture and implement. In addition, it allows an active form of magic angle adjustment, i.e. the angle can be monitored and/or corrected during an experiment, or the angle can be easier changed during the experiment.

As will also be explained in greater detail below, the stator according to the present invention is preferably received in a probe of a magnetic resonance spectrometer. The probe can correspond to a probe as it is known in the art and that can be used together with a commercially available NMR spectrometer. The spectrometer employs magnets that provide a static magnetic field. The spectrometer may furthermore comprise a bore extending centrally through the magnets and which probe is configured to receive the probe. Alternatively, it is likewise conceivable that the probe is used in the fringe field of a magnet, wherein the probe is not received within a bore of a spectrometer but that the probe, in particular the rotor and stator, are placed in the vicinity of the magnet of the NMR spectrometer instead. In the installed state, the probe extends along a longitudinal direction and along the direction of the static magnetic field. When the stator according to the invention is received in the probe, the adjustment axis of the stator mentioned above and the direction of the static magnetic field are preferably parallel to one another and particularly preferably coincide. The adjustment device according to the present invention is thus configured to minimize or even remove a deviation between i) an actual angle being enclosed by the axis of rotation of the rotor being received in the stator and the direction of the static magnetic field and ii) said magic angle. Consequently, the force generated by the adjustment device on the rotor shifts or moves the rotor and thus its axis of rotation such that the axis of rotation of the rotor and the adjustment axis of the stator enclose an angle that matches or at least essentially matches said magic angle. A state wherein the stator is received in the probe and wherein the probe is arranged in the spectrometer is referred to as an installed state of the stator. In this installed state, the adjustment axis of the stator mentioned above runs parallel to a vertical axis of the spectrometer. The vertical axis extends from a ground on which the spectrometer is arranged on vertically upwards.

As mentioned above, the stator is preferably configured to adjust the axis of rotation of the rotor being received in the receptacle and the adjustment axis of the stator in a non-mechanical manner. Additionally or alternatively, the stator is preferably configured to adjust the axis of rotation of the rotor being received in the receptacle and the adjustment axis of the stator while the stator is stationary.

In particular, the at least one adjustment device is preferably configured to adjust the axis of rotation of the rotor being received in the receptacle and the adjustment axis of the stator in a non-mechanical manner. Additionally or alternatively the at least one adjustment device is preferably configured to adjust the axis of rotation of the rotor being received in the receptacle and the adjustment axis of the stator while the stator is stationary and/or while the adjustment device is stationary and/or while the rotation device is stationary.

To this end it is also preferred that the adjustment of the axis of rotation of the rotor relative to the adjustment axis of the stator is achieved while the at least one rotation device rotates the rotor within the receptacle in a non-mechanical manner. Additionally or alternatively it is preferred that the adjustment of the axis of rotation of the rotor relative to the adjustment axis of the stator is achieved while the stator is stationary and/or while the adjustment device is stationary and/or while the rotation device is stationary.

The expression "stationary" is understood as immovable or fixed in space. The expression "in a non-mechanical manner" is understood as an adjustment being achieved without a mechanical connection or physical connection or structural connection being established between the stator, in particular between the adjustment device and/or between the rotation device, and the rotor. That is, the adjustment does not involve a mechanical movement but rather only the application of a force or changes in the applied force exerted by the stator, in particular by the adjustment device and possibly also by the rotation device.

The at least one adjustment device and the at least one rotation device are in each case preferably configured to exert a force on the rotor such that a combination, in particular a linear combination of the force exerted by the adjustment device and the force exerted by the rotation device results in a total force, and wherein said total force adjusts the axis of rotation of the rotor relative to the adjustment axis of the stator.

A force exerted or applied by the adjustment device on the rotor preferably induces a torque on the rotor that causes the rotor to gain angular momentum about an axis associated with that torque. Likewise, a force exerted or applied by the rotation device on the rotor preferably induces a torque on the rotor that causes the rotor to gain angular momentum about an axis associated with that torque. A combination, in particular a linear combination, of i) the torque and/or of the angular momentum imparted by the adjustment device and ii) the torque and/or the angular momentum imparted by the rotation device preferably results in a total torque and/or in a total angular momentum that is imparted on the rotor being received in the receptacle, and wherein said total torque and/or said total angular momentum adjusts the axis of rotation of the rotor relative to the adjustment axis of the stator.

To this end it is preferred that the at least adjustment device and the at least one rotation device are arranged such, that the adjustment device exerts its force and/or torque at a location on the rotor which is different from or the same as a location where the at least one rotation device exerts its force and/or torque on the rotor.

Additionally or alternatively it is preferred that the at least one adjustment device and the at least one rotation device are arranged such, that the force and/or the torque exerted by the at least one adjustment device and/or the angular momentum imparted by the at least one adjustment device extends along a direction being different from or the same as a direction along which the force and/or the torque exerted by the at least one rotation device and/or the angular momentum imparted by the at least one rotation device extends.

Additionally or alternatively it is preferred that the at least one adjustment device and the at least one rotation device are arranged such, that a magnitude of the force and/or a magnitude of the torque exerted by the at least one adjustment device and/or a magnitude of the angular momentum imparted by the at least one adjustment device is different from or the same as a magnitude of the force and/or a magnitude of the torque exerted by the at least one rotation device and/or a magnitude of the angular momentum imparted by the at least one rotation device.

Furthermore, a magnitude of force, and consequently a magnitude of torque and/or a magnitude of angular momentum, exerted or imparted by the at least one adjustment device preferably equals to or is different from a magnitude of force, and consequently a magnitude of torque and/or a magnitude of angular momentum, exerted or imparted by the at least one rotation device. In the latter case the magnitude of force (or the magnitude of torque or the magnitude of angular momentum) exerted by the at least one adjustment device can be larger or smaller than the magnitude of force (or the magnitude of torque or the magnitude of angular momentum) exerted by the at least one rotation device. To this end it is preferred that the magnitude of force (or the magnitude of torque or the magnitude of angular momentum) exerted by the at least one adjustment device is smaller than the magnitude of force (or the magnitude of torque or the magnitude of angular momentum) exerted by the at least one rotation device. For example, the magnitude of force (or the magnitude of torque or the magnitude of angular momentum) exerted by the at least one adjustment device could be 99% or less, for example 70% or less or 20 % or less than the magnitude of force (or the magnitude of torque or the magnitude of angular momentum) exerted by the at least one rotation device.

In this context it is important to note that the at least one rotation device and the at least one adjustment device can be arranged and/or configured such, that they exert a balanced force and/or balanced torque and/or balanced angular momentum on the rotor. The expression "balanced" is herein understood as essentially equal or equal, e.g. a force exerted by the rotation device being 50 % of a total force being exerted on the rotor and a force exerted by the adjustment device being 50 % of said total force. As such, the rotation device can be seen as a first adjustment-rotation device and the rotation device can be seen as a second adjustment-rotation device. Explanations provided herein with regard to the rotation device and the adjustment device thus likewise apply to the case of a first adjustment-rotation device and a second adjustment device and vice versa.

The at least one rotation device can comprise at least one fluid aperture that is configured to supply a fluid to the rotor. Additionally or alternatively the at least one rotation device can comprise at least one electrical conductor that is configured to supply an electrical current to the rotor. Additionally or alternatively the at least one rotation device can comprise at least one optical source that is configured to supply electromagnetic waves to the rotor. Hence, the force and/or the torque and or the angular momentum exerted by the rotation device is preferably provided from fluid and/or from electrical current and/or from electromagnetic waves impinging on the rotor.

Additionally or alternatively the at least one adjustment device can comprise at least one fluid aperture that is configured to supply a fluid to the rotor. Additionally or alternatively the at least one adjustment device can comprise at least one electrical conductor that is configured to supply an electrical current to the rotor. Additionally or alternatively the at least one adjustment device can comprise at least one optical source that is configured to supply electromagnetic waves to the rotor. Hence, the force and/or the torque and or the angular momentum exerted by the adjustment device is preferably provided from fluid and/or from electrical current and/or from electromagnetic waves impinging on the rotor.

Thus, the adjustment device and/or the rotation device can be configured to pneumatically adjust the axis of rotation of the rotor relative to the adjustment axis of the stator. The adjustment device and/or the rotation device can be configured to supply a fluid comprising or consisting of a gas and/or a superfluid and/or a liquid such as air, nitrogen gas, helium gas, superfluid helium liquid, helium liquid, nitrogen liquid, etc. It should be noted that any fluid as it is known in the art is conceivable. The at least one electrical conductor preferably corresponds to an electrode. The at least one optical source preferably corresponds to a laser.

The torque or force exerted by the adjustment device or the angular momentum imparted by the adjustment device preferably depends from a flow rate of the fluid when the adjustment device comprises a fluid aperture and/or from a potential of the electrical conductor and/or from a current supplied to the electrical conductor when the adjustment device comprises an electrical conductor and/or from a frequency and/or a focus and/or an intensity and/or an energy and/or a number of photons and/or a polarization of the electromagnetic radiation being emitted from the adjustment device in the form of an optical source.

Likewise, the torque or force exerted by the rotation device or the angular momentum imparted by the rotation device preferably depends from a flow rate of the fluid when the rotation device comprises a fluid aperture and/or from a potential of the electrical conductor and/or from a current supplied to the electrical conductor when the rotation device comprises an electrical conductor and/or from a frequency and/or a focus and/or an intensity and/or an energy and/or a number of photons and/or a polarization of the electromagnetic radiation being emitted from the rotation device in the form of an optical source.

A distance between the adjustment device and a surface of the rotor preferably is in the nanometer range to the meter range, more preferably in the millimeter range, such as in the range of about 0.0001 millimeter to 10 meter, or in the range of about 0.0001 millimeter to 20 millimeter. A preferred distance is about 0.1 millimeter. A dimeter of the adjustment device in the form of the fluid aperture is preferably in the nanometer range to millimeter range, more preferably in the micrometer range to millimeter range such as in the range of about 0.0001 millimeter to 20 millimeter, particularly preferably approximately 0.5 millimeter. A flow rate of the fluid supplied by the adjustment device in the form of the fluid aperture is preferably in the range of about 0.0001 liter per minute to 10'000 liter per minute, more preferably in the range of about 0.1 liter per minute to 100 liter per minute, particularly preferably approximately 2 liter per minute. A potential supplied by the adjustment device in the form of the electrical conductor preferably is in the range of about 0.1 microvolt to 1000 kilovolt, more preferably in the range of about 0.1 kilovolt to 100 kilovolt, particularly preferably approximately 5 kilovolt. A current supplied by the adjustment device in the form of the electrical conductor preferably is in the range of about 0.1 nano Ampere to 20 kilo Ampere, more preferably in the range of micro Ampere to Ampere, such as in the range of about 0.1 Ampere to 100 Ampere, particularly preferably 2 Ampere. A wavelength supplied by the adjustment device in the form of the optical source preferably is in the range of about 1 nanometer to 100 micrometer, more preferably in the range of about 100 nanometer to 1000 nanometer, and particularly preferably 520 nanometer. A focus supplied by the adjustment device in the form of the optical source preferably is in the range to yield a spot size of about 10 nanometer to 20 milimeter, particularly preferably about 0.5 milimeter, wherein the focus is preferably chosen in accordance with a size of the rotor. A polarization of the electromagnetic radiation emitted by the adjustment device in the form of the optical source preferably is circular or linear. A circular polarization of the electromagnetic radiation is preferred when the electromagnetic radiation being emitted from the optical source propagates along the axis of rotation of the rotor. A linear polarization of the electromagnetic radiation is preferred when the electromagnetic radiation being emitted from the optical source propagates orthogonal to the axis of rotation of the rotor.

A distance between the rotation device and a surface of the rotor preferably is in the nanometer range to the meter range, more preferably in the millimeter range, such as in the range of about 0.0001 millimeter to 10 meter, or in the range of about 0.0001 millimeter to 20 millimeter. A preferred distance is about 0.1 millimeter. A dimeter of the rotation device in the form of the fluid aperture is preferably in the nanometer range to millimeter range, more preferably in the micrometer range to millimeter range such as in the range of about 0.0001 millimeter to 20 millimeter, particularly preferably approximately 0.5 millimeter. A flow rate of the fluid supplied by the rotation device in the form of the fluid aperture is preferably in the range of about 0.0001 liter per minute to 10'000 liter per minute, more preferably in the range of about 0.1 liter per minute to 100 liter per minute, particularly preferably approximately 2 liter per minute. A potential supplied by the rotation device in the form of the electrical conductor preferably is in the range of about 0.1 microvolt to 1000 kilovolt, more preferably in the range of about 0.1 kilovolt to 100 kilovolt, particularly preferably approximately 5 kilovolt. A current supplied by the rotation device in the form of the electrical conductor preferably is in the range of about 0.1 nano Ampere to 20 kilo Ampere, more preferably in the range of micro Ampere to Ampere, such as in the range of about 0.1 Ampere to 100 Ampere, particularly preferably 2 Ampere. A wavelength supplied by the rotation device in the form of the optical source preferably is in the range of about 1 nanometer to 100 micrometer, more preferably in the range of about 100 nanometer to 1000 nanometer, and particularly preferably 520 nanometer. A focus supplied by the rotation device in the form of the optical source preferably is in the range to yield a spot size of about 10 nanometer to 20 milimeter, particularly preferably about 0.5 milimeter, wherein the focus is preferably chosen in accordance with a size of the rotor. A polarization of the electromagnetic radiation emitted by the rotation device in the form of the optical source preferably is circular or linear. A circular polarization of the electromagnetic radiation is preferred when the electromagnetic radiation being emitted from the optical source propagates along the axis of rotation of the rotor. A linear polarization of the electromagnetic radiation is preferred when the electromagnetic radiation being emitted from the optical source propagates orthogonal to the axis of rotation of the rotor.

The at least one adjustment device is preferably configured to continuously adjust the axis of rotation of the rotor relative to the adjustment axis of the stator. A continuous adjustment is an adjustment being performed while an NMR spectrometer performs an experiment such as records an NMR spectrum of a sample being received in the rotor.

The axis of rotation of the rotor relative to the adjustment axis of the stator is preferably adjustable by changing the flow rate of the fluid and/or by changing the potential of the electrical conductor and/or by changing the current supplied to the electrical conductor and/or by changing at least one of a frequency, a focus, an intensity, an energy, a number of photons or a polarization of the electromagnetic radiation being supplied by the at least one adjustment device.

Additionally or alternatively the axis of rotation of the rotor relative to the adjustment axis of the stator is preferably adjustable while an action of the at least one rotation device remains constant. A constant action could be a constant flow rate of fluid being supplied by the rotation device and/or a constant potential being supplied by the rotation device and/or a constant current being supplied to the rotation device and/or a constant frequency and/or a constant focus and/or a constant intensity and/or a constant energy and/or a constant number of photons and/or a constant polarization of the electromagnetic radiation being supplied by the rotation device. The expression "constant" is understood as undergoing no or only a minimal change over time.

The at least one adjustment device is preferably at least partially arranged within the stator and particularly preferably at least partially within the receptacle. Additionally or alternatively the at least one rotation device is preferably at least partially arranged within the stator and particularly preferably is at least partially arranged within the receptacle. For example, the fluid aperture and/or the electrical conductor and/or an exit orifice of an optical fiber being connected to an optical source such as a laser could be arranged at least partially within the stator, in particular at least partially within the receptacle. In other words, it is preferred that at least part of the adjustment device and/or at least part of the rotation device is integrated into the stator, in particular into the receptacle. Again in other words, it is preferred that at least part of the adjustment device and/or at least part of the rotation device is a constituent of the stator, in particular of the receptacle.

The at least one adjustment device and the at least one rotation device are preferably arranged on opposite sides with respect to a longitudinal axis of the stator. Alternatively, it is likewise conceivable that the at least one adjustment device and the at least one rotation device are arranged on a same side with respect to the longitudinal axis of the stator.

Additionally or alternatively it is preferred that the at least one rotation device and the at least one adjustment device are arranged offset with respect to one another and with respect to the longitudinal axis of the stator. Alternatively, it is likewise conceivable that the at least one rotation device and the at least one adjustment device are arranged opposite one another and with respect to the longitudinal axis of the stator.

A cross-section of the receptacle preferably has a circular shape or an essentially circular shape or an at least partially circular shape. Additionally or alternatively, the receptacle is preferably configured such as to receive a spherical rotor. However, it should be noted that any other shapes are likewise conceivable, e.g. a receptacle having a cylindrical shape, the shape of a rhombus, of an ellipsoid, etc. and/or a receptacle being configured to receive a cylindrical rotor, a rotor in the shape of a rhombus, or an ellipsoid, etc.

The receptacle particularly preferably constitutes a so-called stator cup, as it is known in the art. In the event of the receptacle being configured to receive a spherical rotor it is preferred that the at least one rotation device is arranged such as to act, in particular to apply a force or torque, at the equator of the rotor.

The stator preferably defines a longitudinal axis and a normal plane. The normal plane runs centrally through a center of the stator and normal to the longitudinal axis of the stator. The at least one rotation device is preferably aligned along a direction that runs within the normal plane. Additionally or alternatively the at least one adjustment device is preferably aligned along a direction that encloses an angle with the normal plane being unequal zero. In particular, said angle preferably is about 54.74° and/or matches or essentially matches the magic angle.

The at least one rotation device is preferably arranged such as to act within the normal plane. For example, and as has been explained above, the at least one rotation device can correspond to a fluid aperture through which fluid can be ejected. In this case, the fluid aperture is preferably arranged such that the fluid is generated within the normal plane.

The at least one rotation device is furthermore preferably arranged such as to act tangentially on a surface of the rotor being received in the receptacle, e.g. by ejecting fluid tangentially on the surface of the rotor.

The at least one adjustment device is preferably arranged such as to act along a direction that encloses an angle with the normal plane being unequal zero. For example, and as has been explained above, the at least one adjustment device can correspond to a fluid aperture through which fluid can be ejected. In this case, the fluid aperture is preferably arranged such that the fluid is generated at an angle with the normal plane being unequal zero.

The at least one adjustment device is furthermore preferably arranged such as to act tangentially on a surface of the rotor being received in the receptacle, e.g. by ejecting fluid tangentially on the surface of the rotor.

The at least one adjustment device is furthermore preferably arranged such that its action on a surface of the receptacle is minimized or minimal while its action on a gap being formed between the receptacle and the surface of the rotor being received in the receptacle is maximized or maximal.

It is furthermore preferred that the at least one adjustment device and the at least one rotation device are arranged such that their actions, e.g. their ejections of fluid, do not interfere with one another. This arrangement is particularly preferred when the rotation device and the adjustment device correspond to sources of fluid that supply fluid to the rotor via fluid apertures.

The longitudinal axis of the stator and the adjustment axis of the stator preferably enclose an angle that matches or essentially matches the magic angle. Thus, when the stator is in the installed state, the longitudinal axis of the stator and the direction of the static magnetic field preferably enclose or essentially enclose the magic angle. In an aligned state of the rotor, i.e. in a state wherein the angle between the axis of rotation of the rotor and the adjustment axis of the stator match or essentially match the magic angle, the axis of rotation of the rotor and the longitudinal axis of the stator coincide. The rotor being received in the receptacle of the stator is thus rotatable about the longitudinal axis of the stator.

In the installed state of the stator, the at least one rotation device is preferably aligned along a direction that extends close to the complement or with respect to the direction of the static magnetic field. That is, an angle between the direction along which the rotation device is aligned and the direction of the static magnetic field is preferably about 35° with respect to the main magnetic field.

Moreover, in the installed state of the stator, the at least one adjustment device is preferably aligned along a direction that extends or essentially extends at an angle relative to the direction of the static magnetic field that is 90°.

In this regard it should be noted that the adjustment device and/or the rotation device can be arranged and/or configured such that the force they individually exert on the rotor results in an alignment of the axis of rotation of the rotor that is not exactly on the magic angle with respect to the direction of the static magnetic field. Instead, the adjustment device can be arranged and/or configured such as to exert a force on the rotor resulting in an alignment of the axis of rotation of the rotor that is above the magic angle and the rotation device can be arranged and/or configured such as to exert a force on the rotor resulting in an alignment of the axis of rotation of the rotor that is below the magic angle (or vice versa), such that the overall force exerted by the rotation device and the adjustment device results in an alignment of the axis of rotation of the rotor that is at the magic angle with respect to the static magnetic field.

It should be noted that in the installed state of the stator an angle between the axis of rotation of the rotor and the static magnetic field is typically the magic angle. However, there are many conceivable experiments where different angles could be desired during different time periods of the experiment. In principle, all angles are conceivable, i.e. angles ranging from 0° to 180° with respect to the static magnetic field.

The stator preferably further comprises at least one further adjustment device, wherein the at least one adjustment device and the at least one further adjustment device are arranged and/or configured such, that the axis of rotation of the rotor is adjusted relative to the adjustment axis of the stator at a desired angle. Additionally or alternatively the stator preferably further comprises at least one further rotation device, wherein the at least one rotation device and the at least one further rotation device are arranged and/or configured such, that the axis of rotation of the rotor is adjusted relative to the adjustment axis of the stator at a desired angle. Additionally or alternatively the at least one rotation device, the at least one further rotation device, the at least rotation device and the at least one further rotation device are preferably arranged and/or configured such, that the axis of rotation of the rotor is adjusted relative to the adjustment axis of the stator at a desired angle.

That is, it is conceivable to have a two or more adjustment devices and/or two or more rotation devices, which are arranged and/or configured such that the rotor rotates about its axis of rotation being arbitrarily aligned with respect to the adjustment axis of the stator. In other words, the adjustment device(s) and/or the rotation device(s) can be controlled in a way to yield a spinning of the rotor at an arbitrary spinning axis.

In a further aspect, a rotor being configured to be received in the receptacle of the stator as described above is provided.

As mentioned earlier, the rotor preferably has a spherical shape or an essentially spherical shape or the shape of a cylinder, the shape of a rhombus, the shape of an ellipsoid, etc. A diameter of the rotor preferably is in the range of about 1 nanometer to 10 centimeter. The rotor preferably comprises a chamber that is configured to receive a sample. The rotor preferably comprises one or more notches that are formed in a surface of the rotor. The one or more notches are preferably equatorially spaced around the axis of rotation of the rotor. Various designs of the notches such as different lengths, different depths different shapes, different cross-sections, or different orientations are conceivable. However, it is likewise conceivable that the rotor has a smooth surface without any notches or the like. The rotor preferably corresponds to a rotor as it is known in the art and which is commercially available.

In a further aspect, a probe for a magnetic resonance spectrometer comprising the stator as described above and preferably furthermore comprising the rotor as described above is provided. It should be noted that any explanations provided with regard to the stator per se and the rotor per se likewise apply to the probe comprising the stator and/or the rotor and vice versa. The probe preferably corresponds to a probe as it is known in the art and which is commercially available.

In a further aspect, a magnetic resonance spectrometer comprising the probe as described above and/or comprising the stator as described above and/or preferably comprising the rotor as described above is provided. It should be noted that any explanations provided with regard to the stator per se and the rotor per se and the probe per se likewise apply to the magnetic resonance spectrometer and vice versa. The NMR spectrometer preferably corresponds to an NMR spectrometer as it is known in the art and which is commercially available.

In a further aspect a method of producing a stator for a probe of a magnetic resonance spectrometer, in particular the stator as described above, is provided. Said method comprises the steps of i) providing a receptacle for receiving a rotor, wherein the receptacle is configured such, that a rotor being received in the receptacle is rotatable about an axis of rotation, ii) providing at least one rotation device that is configured to generate a rotation of the rotor being received in the receptacle about the axis of rotation, and iii) providing the stator with at least one adjustment device that is configured to generate a force on the rotor being received in the receptacle so as to adjust the axis of rotation of the rotor relative to an adjustment axis of the stator.

It should be noted that steps i) to iii) can be performed in any order. It should furthermore be noted that any explanations provided with regard to the stator per se, the rotor per se, the probe per se and the nuclear magnetic resonance spectrometer per se likewise apply to the method of producing the stator for a probe of a magnetic resonance spectrometer and vice versa.

The stator can be made of any material suitable for use as a stator. For example, the stator can comprise a polymer, preferably one or more polymers used in 3D printing such as acrylonitrile-butadiene-styrene, boron nitride, carbon, Teflon™, zirconia (e.g. yttria-stabilized zirconia $ZrO_2$), silicon nitride (e.g. $Si_3N_4$), Macor, Kel-F, Torlon, Aurum, Vespel, glass-fiber-reinforced Torlon (GFT), or diamond. The receptacle, in particular the entire stator, is preferably provided by 3D printing as it is known in the art.

The rotor can be made of any material suitable for NMR spectroscopy and as is well-known in the art. The rotor may comprise a polymer, preferably one or more polymers used in 3D printing such as such as acrylonitrile-butadiene-styrene, zirconia, sapphire, quartz, photoresists, diamond, boron nitride, carbon, Teflon™, silicon nitride, Macor, Kel-F, Torlon, Aurum, Vespel, or glass-fiber-reinforced Torlon. The rotor is preferably produced by 3D printing as it is known in the art as well.

In a further aspect, a method of adjusting an axis of rotation of a rotor relative to an adjustment axis of a stator in a magnetic resonance spectrometer is provided. Said method comprises the steps of i) placing the rotor into a receptacle of the stator, ii) rotating the rotor being received in the receptacle about the axis of rotation of the rotor by at least one rotation device, and iii) generating a force on the rotor being received in the receptacle by at least one adjustment device of the stator, whereby the axis of rotation of the rotor relative to the adjustment axis of the stator is adjusted.

The steps i) to iii) are preferably performed in this sequence.

The method preferably further comprises the steps of measuring at least one magnetic resonance spectrum with the magnetic resonance spectrometer and comparing and/or correlating said at least one measured spectrum with at least one reference spectrum, and wherein the force is generated based on said comparison.

It is furthermore conceivable that the axis of rotation of the rotor relative to the adjustment axis of the stator is continuously and/or repeatedly monitored and/or adjusted during an experiment. Thus, the method preferably further comprises the steps of changing the force exerted by the adjustment device and/or by the rotation device during the measurement of the magnetic resonance spectrum.

In a further aspect, a computer program product comprising executable instructions stored in a non-transient computer readable medium is provided, which instructions, when being executed by a processing unit, carry out or control the method as described above.

BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

Fig. 1      shows a perspective view of an NMR probe head comprising a stator and a rotor;
Fig. 2      shows a perspective view of the rotor according to figure 1;
Fig. 3      shows a sectional view of the rotor according to figure 2;
Fig. 4      shows a perspective view of a stator according to the invention, wherein the stator comprises an adjustment device and a rotation device;
Fig. 5      shows a partial sectional view of the stator according to figure 4;
Fig. 6      shows a partial sectional view of the stator according to figure 4, wherein a rotor is received in the stator;
Fig. 7      shows a graphic depicting two point forces being applied tangent to a surface of a sphere to represent an action of the adjustment device and of the rotation device of the stator on the rotor and the resultant torque vector;
Fig. 8      shows simulated NMR spectra for the first order sideband of the COOD $^2$H resonance as a function of sample rotation angle at a rate of 3000 Hz, using a $C_q$ value of 180 kHz and an $\eta_q$ value of 0.11;
Fig. 9      shows a calibration curve of the spinning axis angle against the difference in ppm between the two inner peaks of the simulated off-angle sideband lineshape for the COOD $^2$H resonance of $d_4$-malonic acid at 3000 Hz rotation rate;
Fig. 10     shows an experimental $^2$H MAS spectrum of $d_4$-malonic acid (upper panel) at 6536 Hz MAS (2 bar helium gas) at the magic angle compared to calculated $^2$H MAS spectrum at the same MAS rate for a single $^2$H resonance with $C_q$ = 180 kHz and $\eta_q$ = 0.11 (lower panel);
Fig. 11     shows $^2$H NMR spectra of the first order sideband in $d_4$-malonic acid as a function of spinning angle at spinning rates ranging between 2869 Hz (54.64°) and 2861 Hz (54.84°) taken with 256 scans per spectrum;

Fig. 12    shows the relationship between measured flow rate of air through the adjustment device of the stator in liters normal per min ($L_n$/min) and the observed spinning angle for the rotor;

Fig. 13    shows a CAD assembly drawing of the rotor packing tool used to pack a 161 $\mu$L volume 9.5 mm O.D. spherical rotor;

Fig. 14    shows simulated spectra of the first order sideband (left) and centerband (right) for a $^2$H spin at 3000 Hz rotation rate as a function of spinning axis angle with respect to the external magnetic field at 7 T;

Fig. 15    shows simulated spectra of the first order sideband (left) and centerband (right) for a $^2$H spin at 30 kHz rotation rate as a function of spinning axis angle with respect to the external magnetic field at 7 T;

Fig. 16    shows simulated spectra of the first order sideband (left) and centerband (right) for a $^2$H spin at 100 kHz rotation rate as a function of spinning axis angle with respect to the external magnetic field at 7 T;

Fig. 17    shows simulated spectra of the first order sideband for a $^2$H spin at 3000 Hz rotation rate as a function of spinning axis angle with respect to the external magnetic field at 7 T (left) and at 21 T (right).

DESCRIPTION OF PREFERRED EMBODIMENTS

Precise alignment of the sample's spinning axis is vital for many magic angle spinning solid state NMR experiments. In order to obtain the highest quality spectra at any MAS rate, the angle $\Theta_s$ at which the sample spins must be tightly controlled and adjusted to account for any orientational changes to the experimental apparatus. While most solid state NMR experiments are insensitive to magic angle offset to within a few hundredths of a degree, there are experiments which require extremely precise setting of the magic angle, such as satellite-transition MAS (ST-MAS). It can also be useful to intentionally spin samples at a precise angle slightly offset from the magic angle to re-introduce residual couplings. Herein below a novel method for setting the magic angle for rotors 3 by using aperture stator 1 comprising at least one adjustment device 6 to pitch the rotor's axis of rotation R within the stator 1 is presented.

Aspects of the stator 1 according to the invention will now be described in greater detail with reference to the figures.

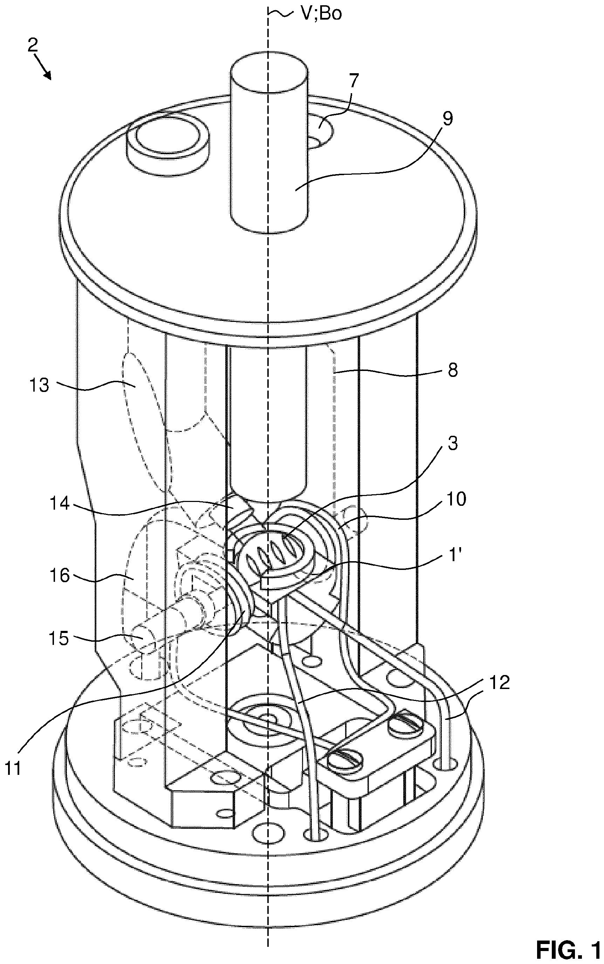

In fact, the stator 1 according to the invention can be received in a probe 2 of a magnetic resonance spectrometer as it is known in the art. The spectrometer employs magnets that provide a static magnetic field B0. Figure 1 depicts a probe 2 for an NMR spectrometer as it is known in the art and described in WO 2019/108754 A1. Said probe 2 corresponds to a DNP NMR probe 2 which comprises a gas inlet 7 and a spinning gas line 8 for supplying a fluid to rotate the rotor 3, a rotor exchange tube 9 through which the rotor 3 can be exchanged, a rotor 3, radio frequency coils such as a transmit-receive coil 10, 11 capable of transmitting and receiving a radiofrequency, fiber optics 12 for spinning frequency detection, a waveguide 13 to transmit microwaves to the sample for DNP, and a microwave lens 14. Hence, the stator 1 according to the invention can be received in such a probe 2 or in any other probe 2 known in the art.

Important to note here is the fact that figure 1 depicts a probe 2 comprising a stator 1' as it is known in the art, wherein an adjustment of the magic angle is achieved via a pivot 15 and a magic angle adjuster 16 that are configured to adjust the angle of the stator 1, in particular of a stator stage, in a mechanical manner.

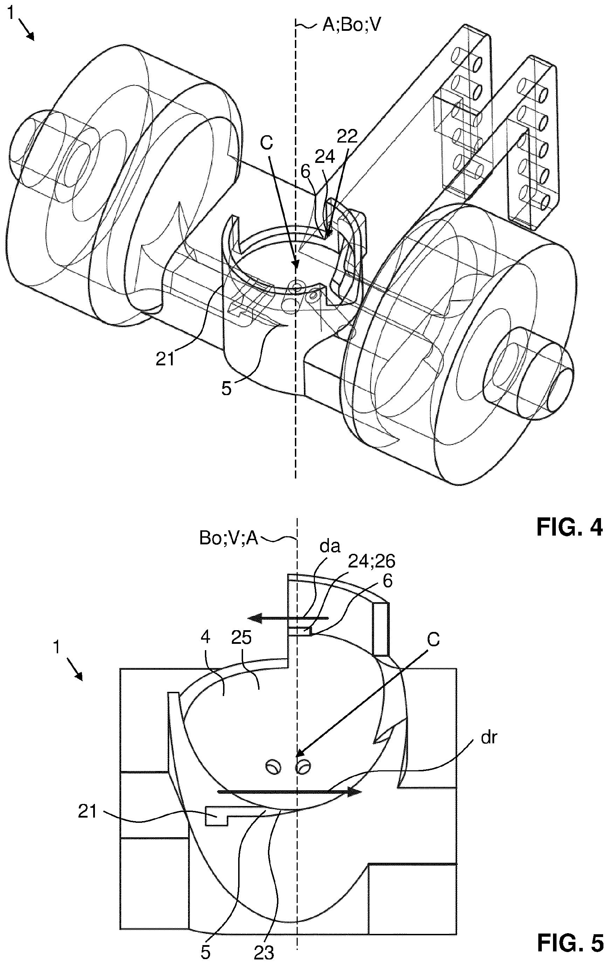

This mechanical adjustment is in clear contrast to the non-mechanical adjustment provided by the stator 1 according to the invention. Namely, and as becomes apparent from figures 4 to 6, the stator 1 according to the invention comprises at least one rotation device 5 that is configured to generate a rotation of the rotor 3 being received in the receptacle 4 about the axis of rotation R of the rotor 3 and at least one adjustment device 6 that is configured to generate a force on the rotor 3 being received in a receptacle 4 of the stator 1 so as to adjust the axis of rotation R of the rotor 3 relative to an adjustment axis A of the stator 1. When the stator 1 according to the invention is received in the probe 2, the adjustment axis A of the stator 1 mentioned above and the direction of the static magnetic field B0 employed by the magnets of the NMR spectrometer are parallel to one another and coincide. The adjustment device 6 according to the present invention is thus configured to minimize or even remove a deviation between i) an actual angle $\Theta_s$ being enclosed by the axis of rotation R of the rotor 3 being received in the stator 1 and the direction of the static magnetic field B0 and ii) the magic angle $\Theta_m$. Consequently, the force generated by the adjustment device 6 on the rotor 3 shifts or moves the rotor 3 and thus its axis of rotation R such that the axis of rotation R of the rotor 3 and the adjustment axis A of the stator 1 enclose an angle $\Theta_s$ that matches or at least essentially matches said magic angle $\Theta_m$. In this installed state, when the stator 1 is received in the probe 2 and the prove is arranged in a spectrometer, the adjustment axis A of the stator 1 runs parallel to a vertical axis V of the spectrometer. The vertical axis V extends from a ground on which the spectrometer is arranged on vertically upwards.

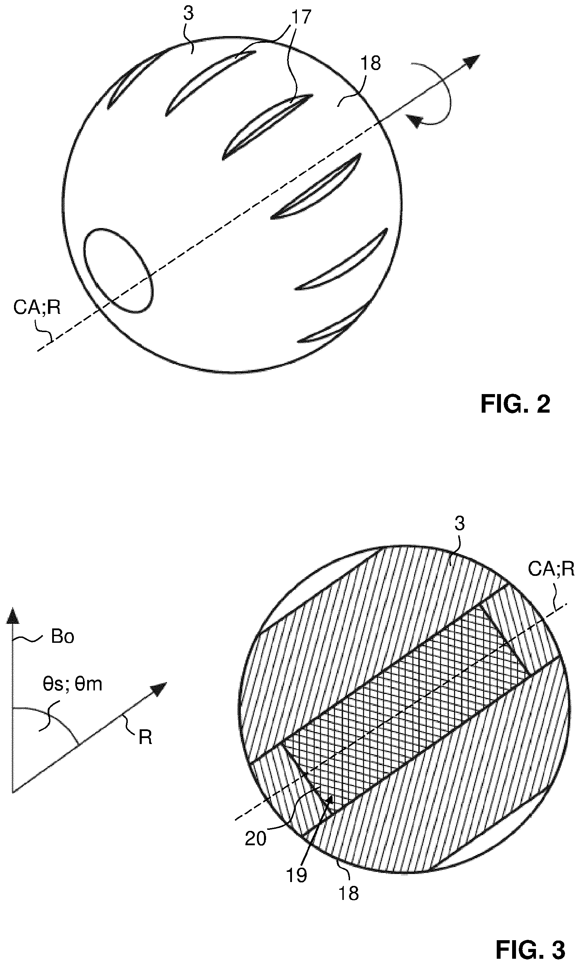

Figures 2 and 3 depict a conceivable rotor 3 that can be used with a stator 1 according to the invention. Here, the rotor 3 corresponds to a spherical rotor 3 although rotors 3 of any other design could be used as well. The rotor 3 comprises a plurality of notches 17 that are formed in a surface 18 of the rotor 3, and wherein said notches 17 are equatorially spaced around a central axis CA of the rotor 3, i.e. here around the axis of rotation R of the rotor 3. Furthermore, and as can be seen in figure 3, the rotor 3 comprises a chamber 19 that is configured to receive a sample 20. In the installed state of the stator 1 and in a state wherein the rotor 3 is received in the stator 1, the central axis CA of the rotor 3, i.e. here the axis of rotation R of the rotor 3, can be aligned with respect to the adjustment axis A of the stator 1 and thus with respect to the direction of the static magnetic field B0. In figure 3, said alignment is such as to match the magic angle $\Theta_m$.

In the depicted example, the adjustment device 6 and the rotation device 5 of the stator 1 are in each case provided by a fluid device that is configured to supply a fluid to the rotor 3. As follows from figures 4 to 6, the fluid devices comprise fluid tubes 21, 22 that extend through the stator 1, in particular from an outside of the stator 1 towards the receptacle 4 of the stator 1. A first end (not depicted) of the fluid tubes 21, 22 can be connected to a source of fluid such as a source of gas. The second end of the fluid tubes 21, 22 terminates in a fluid aperture 23, 24 that is formed on the inner surface 25 of the receptacle 4 which faces a rotor 3 being received in the receptacle 4. Hence, the examples depicted herein disclose an adjustment device 6 and a rotation device 5 being configured to pneumatically adjust the axis of rotation R of the rotor 3 relative to the adjustment axis A of the stator 1. However, other adjustments such as an adjustment by means of electrical conductor supplying an electrical current to the rotor 3 or an optical source such as a laser supplying electromagnetic waves to the rotor 3 are likewise conceivable. For instance, in the former case electrodes could be arranged at the positions of the fluid apertures 23, 24. In the latter case, the fluid tubes 21, 22 could be replaced by optical waveguides or the like that allow a propagation of electromagnetic radiation, and wherein the exit orifices of the optical waveguides could be arranged at the positions of the fluid apertures 23, 24. In any case, both the adjustment device 6 and the rotation device 5 are at least partially arranged within the receptacle 4, and are in particular formed as an at least partial integral component of the receptacle 4.

In the present example the stator 1 looks like a "T" because the two fluid tubes 21, 22, here gas supply lines, are connected opposite each other through the "legs"-this also allows for older style mechanical adjustment of the angle, as the connection points between the stator and legs are also pivot points. There is a single RF coil for NMR excitation and detection. There are also two fiber optic cables connected to a tachometer housed outside the probe; these cables need to terminate close to the rotor 3 so they can detect the different in light absorption when a black mark on the white rotor 3 spins around.

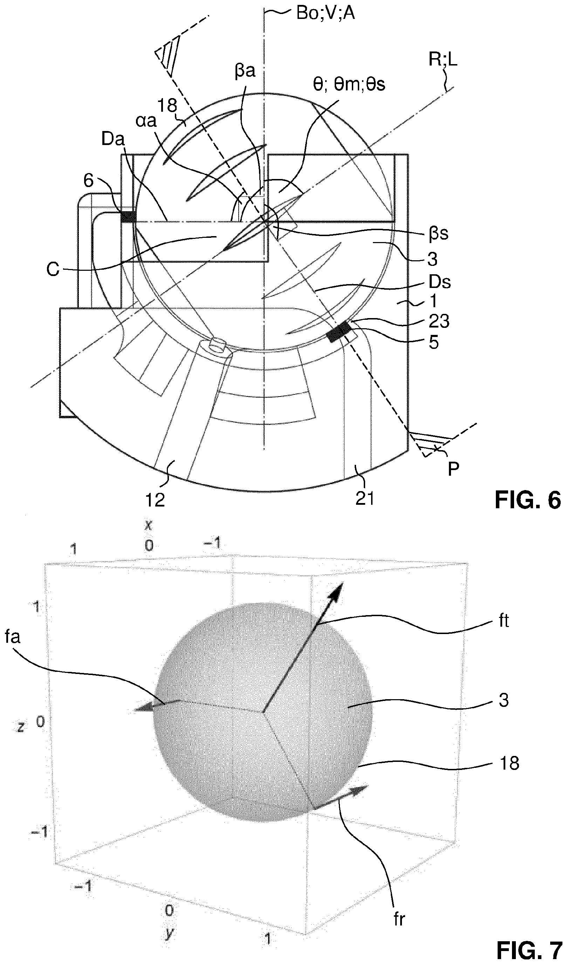

The adjustment device 6 and the rotation device 5 are configured to generate a force on the rotor 3. In the depicted example, the adjustment device 6 and the rotation device 5 are arranged such, that the adjustment device 6 exerts its force at a location on the rotor 3 which is different from a location where the at least one rotation device 5 exerts its force on the rotor 3. Furthermore, and as follows from figure 5, a gas flow supplied by the adjustment device 6 and a gas flow supplied by the rotation device 5 are flowing along different directions. In fact, the direction da of the gas flow of the adjustment device 6 extends opposite to the direction dr of the gas flow of the rotation device 5, see also explanations made with respect to figure 7 below.

This extension is a result of the particular arrangement of the adjustment device 6 and the rotation device 5. Namely, and as indicated in figure 6, the stator 1 defines a longitudinal axis L and a normal plane P running centrally through a center C of the stator 1 and normal to the longitudinal axis L of the stator 1. In the present example the rotation device 5 is aligned along a direction Ds that runs within the normal plane P and the adjustment device 6 is aligned along a direction Da that encloses an angle $\alpha a$ with the normal plane P being here about 54.74°, i.e. matching the magic angle $\Theta_m$. Thus, the rotation device 5 is arranged such as to act within the normal plane P. In fact, its fluid aperture 23 is arranged such that the fluid is supplied within the normal plane P. Moreover, the rotation device 5 is arranged such as to act tangentially on the surface 18 of the rotor 3 being received in the receptacle 4, wherein its fluid aperture 23 ejects fluid tangentially on the surface 18 of the rotor 3. As just explained, the adjustment device 6 is arranged such as to act along a direction Da that encloses an angle $\alpha a$ with the normal plane P being unequal zero, here namely 54.74°. In particular, its fluid aperture 24 is arranged such that the fluid is supplied to the rotor 3 at an angle with the normal plane P, and wherein said angle is unequal zero, namely 54.74°. Moreover, also the adjustment device 6 is arranged such as to act tangentially on a surface of the rotor 3 being received in the receptacle 4, wherein its fluid aperture ejects fluid tangentially on the surface of the rotor 3.

Moreover, the adjustment device 6 is arranged such that its action on the inner surface 25 of the receptacle 4 is minimal while its action on a gap being formed between the inner surface 25 of the receptacle 4 and the surface 18 of the rotor 3 being received in the receptacle 4 is maximal.

However, it is important to note that other arrangements of the rotation device 5 and the adjustment device 6 and/or a more balanced generation of force on the rotor 3 by the rotation device 5 and the adjustment device 6 are likewise conceivable. For instance, it is conceivable to arrange and/or configure the rotation device 5 and the adjustment device 6 such, that they supply a balanced amount of torque to the rotor 3. Said balanced amount of torque could be close to 50 % / 50 %, for example. As such, the rotation device 5 could be understood as a first adjustment-rotation device 5 and the rotation device could be understood as a second adjustment-rotation device 6.

The longitudinal axis L of the stator 1 and the adjustment axis A of the stator 1 enclose an angle $\alpha s$ that matches the magic angle $\Theta_m$. Thus, when the stator 1 is in the installed state, the longitudinal axis L of the stator 1 and the direction of the static magnetic field B0 enclose the magic angle $\Theta_m$. In an aligned state of the rotor 3, i.e. in a state wherein the angle $\Theta_s$ between the axis of rotation R of the rotor 3 and the adjustment axis A of the stator 1 match the

magic angle $\Theta_m$, the axis of rotation R of the rotor 3 and the longitudinal axis L of the stator 1 coincide. In this state, the rotor 3 being received in the receptacle 4 of the stator 1 is thus rotatable about the longitudinal axis L of the stator 1.

In the installed state of the stator 1, the at least one rotation device 5 is preferably aligned along a direction Ds that extends essentially at the complement of the magic angle $\Theta_m$ with respect to the direction of the static magnetic field B0. That is, an angle $\beta$s between the rotation device 5 and the direction of the static magnetic field B0 is here about 125°. However, it should be noted that other angels are likewise conceivable. For example, angles of 34 and 36 degrees (split about the complement to the magic angle with forces nearly matched, or angles of 34 and 40 degrees (with more force from the 34 degree aperture) could likewise be used, etc. Moreover, in the installed state of the stator 1, the adjustment device 6 is aligned along a direction Da that essentially extends at an angle $\beta$a relative to the direction of the static magnetic field B0 that is 90°.

Moreover, in the depicted example the adjustment device 6 and the rotation device 5 are arranged on opposite sides with respect to the longitudinal axis L of the stator 1. Additionally, the rotation device 5 and the adjustment device 6 are arranged offset with respect to one another and with respect to the longitudinal axis L of the stator 1.

As follows from figure 7, a point force applied tangent to the surface of a sphere symbolizing the rotor 3 will induce a torque that causes the sphere to gain angular momentum about the axis associated with that torque. A second point force applied to the surface of the sphere at a different point will cause the angular momentum vector to change direction and magnitude based on the sum of the two torques on the sphere. Figure 7 depicts two point forces applied in opposite directions tangent to a sphere along the x-axis at points that lie in the yz-plane, approximating the forces experienced by the spherical rotor 3 being received in the stator 1 according to the invention. The resultant torque is aligned with the rotor's angular momentum vector, and is the orientation of the axis of rotation R of the rotor 3, i.e. the rotor's spinning axis R. When only the drive force fr is applied, i.e. the force fr exerted by the rotation device 5, the angular momentum vector is at an angle of 55.740 with respect to the z-axis. As the angle adjust force fa, i.e. the force fa exerted by the adjustment device 6, is increased, the angle between the z-axis and the angular momentum vector decreases, while at the same time, the magnitude of the angular momentum vector must increase. This implies a monotonic relationship between the flow rate of the fluid supplied by the adjustment device 6, the spinning rate at which the rotor 3 is rotated about its axis of rotation R, and the angle of the rotor's axis of rotation R. The total force vector ft is the result of the two point forces fr and fa being applied tangent to the surface of the sphere. The placement of the fluid aperture 24 of the adjustment device 6 within the receptacle 4 of the stator 1, i.e. the stator cup 4, is significant. Furthermore, by placing the fluid aperture 23 of the rotation device 5 on the opposite side of the rotor 3, the two gas streams will not interfere with one another. It furthermore follows from figure 7 that the adjustment device 6 and the rotation device 5 are arranged such, that the force fa and/or the torque exerted by the adjustment device 6 and the angular momentum imparted by the at least one adjustment device 6 extends along a direction being different from a direction along which the force fr and/or the torque exerted by the at least one rotation device 5 and/or the angular momentum imparted by the at least one rotation device 5 extends.

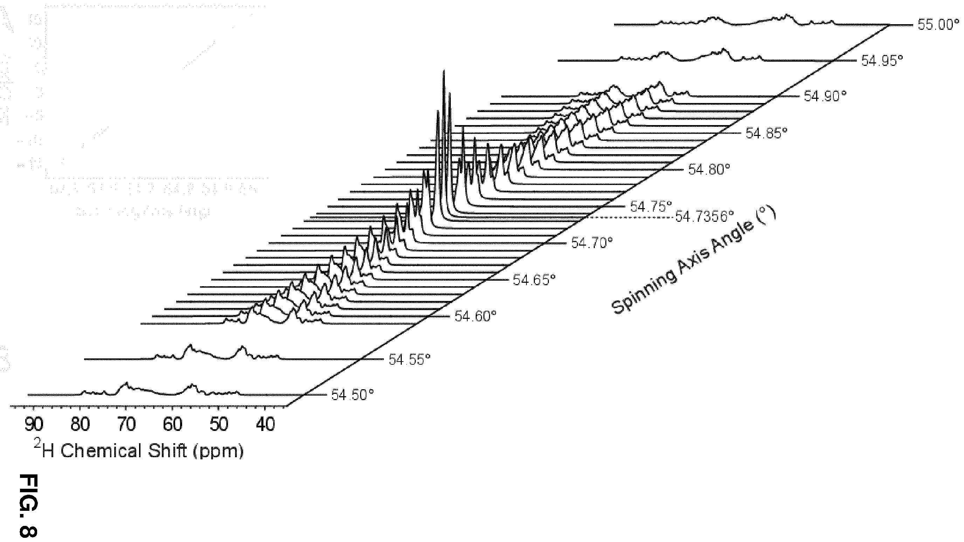

With regard to figures 8 to 17 the working principle of the present invention shall be further demonstrated.

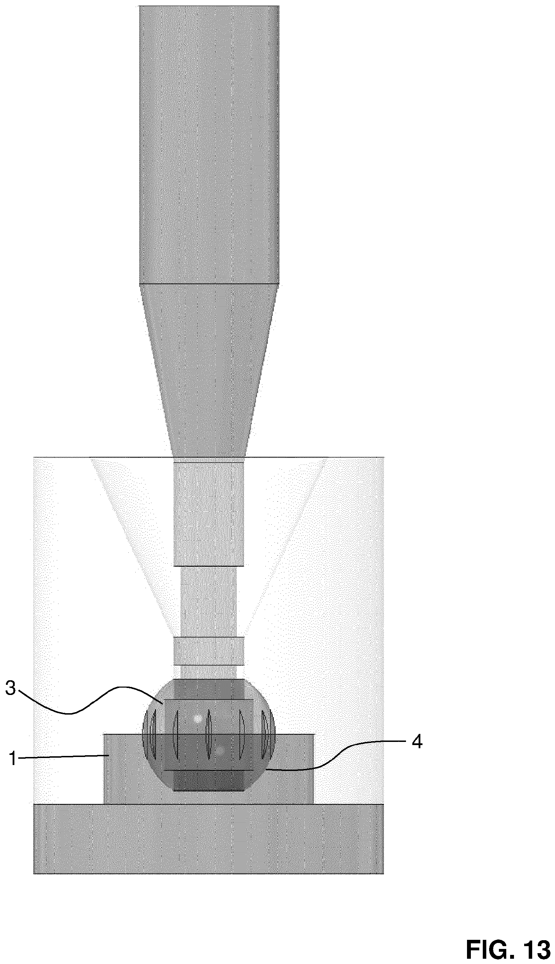

The stator 1 for spinning the rotor 3 was 3D-printed in a clear acrylonitrile- butadiene-styrene (ABS)-like polymer using a Projet MJP2500 3D printer (3D Systems, Rock Hill, SC, US). The stator 1 was installed into a modified double-resonance APEX-style Chemagnetics probe 2 using a double-saddle coil for NMR signal excitation and detection as known in the art. A 9.5 mm rotor 3 machined from yttria-stabilized zirconia with a 161 $\mu$L sample chamber and 12 0.35 mm depth 60-degree V-shaped grooves (O'Keefe Ceramics, Woodland Park, CO, US) was used for the NMR experiments. The rotor 3 was packed with 180.1 mg of $d_4$-malonic acid (98% atom percent deuterium, Sigma Aldrich) using specially- designed rotor 3 packing tools to ensure even distribution of material (figure 13), and sealed at both ends using spherically-contoured (4.75 mm radius) 3D-printed ABS-like plastic caps. The protrusion in the hemispherical cup 4 on the base piece serves to align the rotor 3 for packing, and to exclude volume into which the cap will be inserted. The end section of the packing rod serves as a guide to exclude volume for the other cap.

The design of the stator 1 for pneumatic angle adjustment of the rotor's spinning axis R is shown in figures 4 to 7. It should be noted that the same stator design can be used for the other types of the non-mechanical adjustment. The rotor 3 is placed into the receptacle 4 of the stator 1, i.e. in the stator cup 4, where the primary contribution to the angular momentum of the rotor 3 comes from the gas flow out of the fluid aperture 23 of the rotation device 5. The fluid aperture 23 of the rotation device 5 is centered just beyond the complement of the magic angle (145.740 from the vertical axis) to apply torque at the equator of the rotor 3, causing the rotor 3 to spin about the axis of rotation R being inclined at 55.740 with respect to the vertical axis V. This aperture geometry is designed to minimize gas flow normal to the surface 25 of the stator cup 4 and to maximize gas flow in the gap between the stator cup 4 and the surface 18 of the rotor 3, resulting in improved stability of the rotor 3 during the spin-up and spin-down procedures. The fluid aperture 24 of the adjustment device 6 is placed at a 90° angle from the vertical axis V on the opposite side of the stator cup 4, producing gas flow in the opposite direction of the gas flow ejected by the rotation device 5. The wall of the stator cup 4 near the fluid aperture of the adjustment device 6 was removed to allow for unimpeded expansion of the gas flow from the fluid aperture 24 of the adjustment device 6, with no adverse effects on the spinning stability of the rotor 3. NMR experiments were performed at 7.05 T using a Bruker Avance III spectrometer (Bruker Corp., Billerica, MA, US). $^2$H MAS spectra were taken at a transmitter frequency of 46.08 MHz using a ,$\pi$/2 pulse of 9 $\mu$s at 300 W incident RF power and with an inter-scan delay of 0.8 s. The $^2$H MAS spectrum depicted in figure 8 was collected at an MAS rate of 6536 Hz using helium gas and processed by summing the spectra obtained by stepping the frequency across the width of the resonance. MAS was performed with either air or helium gas, where the pressure of the fluid ejected from the rotation device 5 was kept constant at 2 bar, and the gas flow rate of the adjustment device 6 was coarsely adjusted by changing the pressure between 0 and 0.5 bar, and finely adjusted using a needle valve to further restrict the gas flow going to the stator 1. The gas flow rate of the adjustment device 6 was monitored using a Red-y compact digital mass flow meter (Vögtlin Instruments, Switzerland). For troubleshooting purposes, a lever arm for mechanical adjustment of the rotor's 3 pitch angle was included in the stator design, but in principle, the probehead 2 can be configured with no mechanically adjustable parts whatsoever.

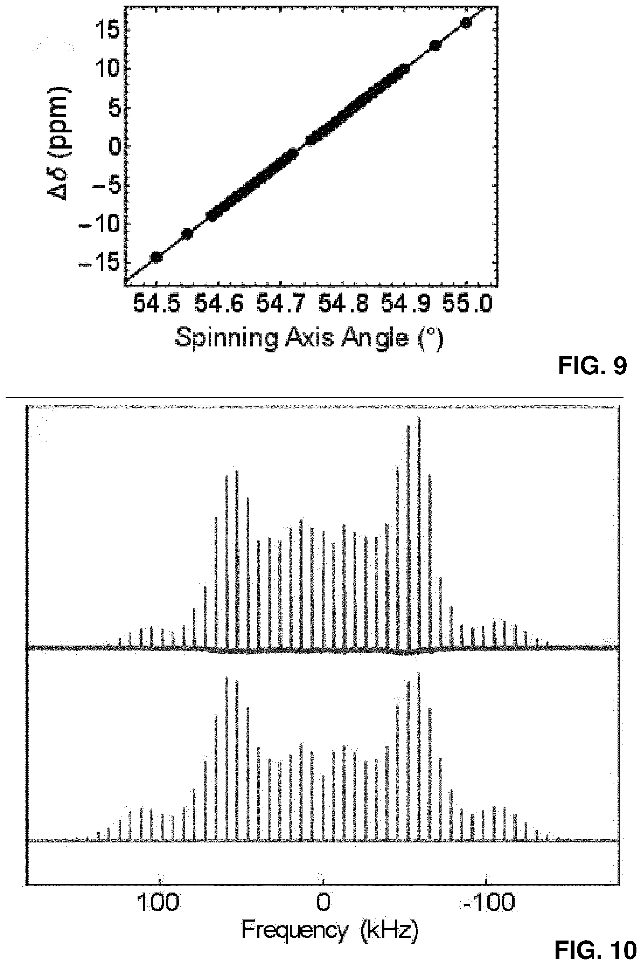

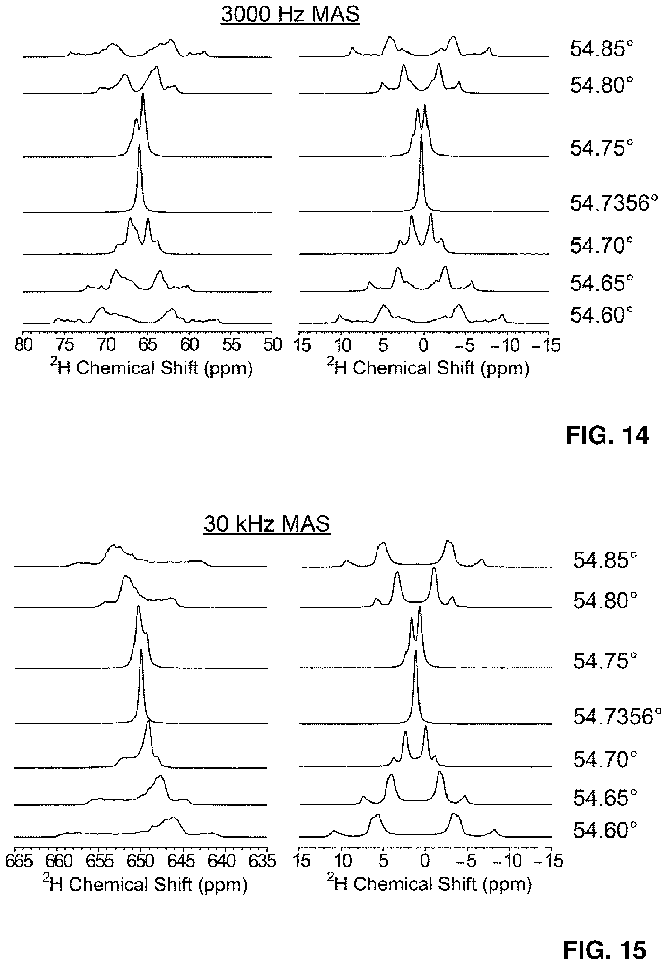

Spectra of the COOD deuteron resonance in $d_4$-malonic acid as a function of MAS angle offset were simulated with the SIMPSON package by calculating the evolution of the quadrupolar interaction to second order for a single spin-1 nucleus while rotating at the magic angle $\Theta_m$ or slightly off the magic angle $\Theta_m$. Spectra were simulated across a range of spinning angles $\Theta_s$ at a rotation rate of 3000 Hz. Additional simulations were performed at different spinning rates (3 kHz, 30 kHz, 100 kHz) and magnetic field strengths (7 T, 21 T) (figures 14-17). The simulated spectrum in figure 10 was simulated in DMFit using the same quadrupolar parameters ($C_q$ and $\eta_q$) that were used for the SIMPSON calculations.

Figure 8 depicts simulated $^2$H NMR spectra for the 1st order sideband of $d_4$-malonic acid as a function of spinning axis angle $\Theta_s$ at 3000 Hz rotation rate. The quadrupole coupling constant, $C_q$, and asymmetry parameter, $\eta_q$, used for the simulations were set to 180 kHz and 0.11, respectively. These values were chosen to be close to the experimentally measured quadrupole parameters for the two nearly-identical COOD crystallographic sites within crystalline malonic acid, which have been previously determined to be $C_q$ = 179.1 kHz, $\eta_q$ = 0.112 for site 1 and $C_q$ = 180.9 kHz, $\eta_q$ = 0.098 for site 2. As a verification that the chosen quadrupolar parameters are suitable for the simulation, the full pattern under MAS was simulated using these values and compared to experiment by spinning the rotor 3 at 6536 Hz using helium gas as shown in figure 10. The sideband lineshape is highly dependent on the angle $\Theta_s$ of the axis of rotation R with respect to the static magnetic field B0, developing into a pattern with two peaks at angle values offset from the magic angle $\Theta_m$. The relative peak heights between the upfield and downfield resonances of the lineshape changes based on whether the angle is pitched above or below the magic angle $\Theta_m$. The center band also manifests as a splitting, but does not have a difference in peak heights between the upfield and downfield peaks as a function of absolute angle offset. A plot of the difference in chemical shift between the shorter and taller peak maxima as a function of spinning axis angle $\Theta_s$ (in degrees) is shown in figure 9, and a linear fit yields the following equation:

$$\Delta\delta = (60.835 \text{ ppm/}°)\, \Theta_s - 3329.88 \text{ ppm} \quad (1)$$

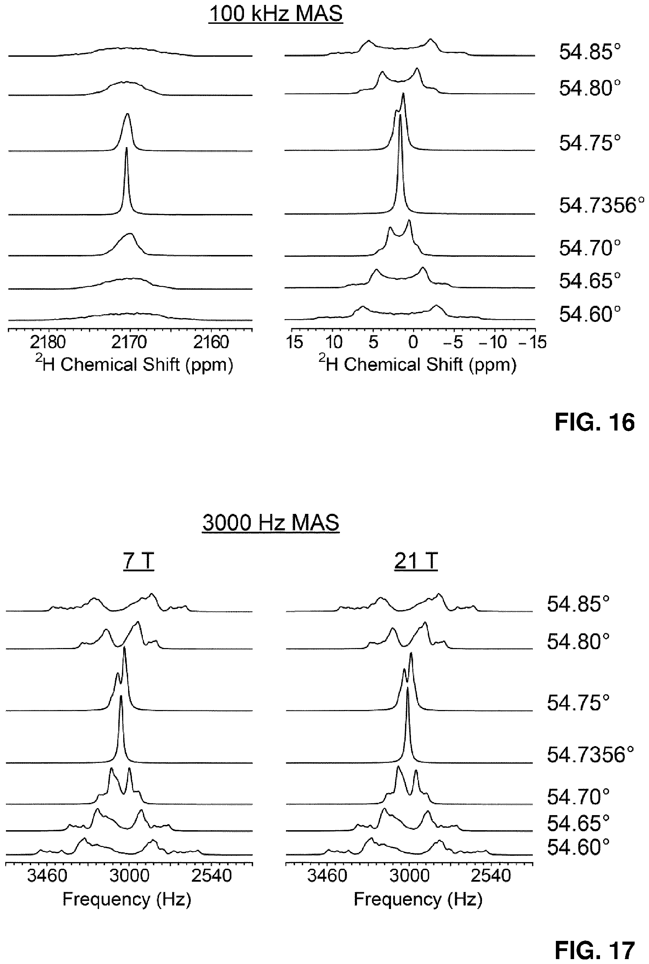

This linear fit is valid only for spinning rates near 3000 Hz where these spectra were simulated, as the off-magic angle lineshape for this resonance changes significantly as a function of spinning rate (figures 13, 14). For example, when spinning at 30 kHz, the first order sideband maintains the property of having an asymmetric lineshape dependent on absolute angle offset, but it no longer manifests as a peak splitting. At 100 kHz, the first order sideband no longer contains much information about angle offset other than through a narrowing of the linewidth at values near the magic angle $\Theta_m$. Though not sensitive to absolute offset, at high spinning rates the center band lineshape does manifest as a peak splitting when spinning off-magic angle. This makes the use of $d_4$-malonic acid or another deuterated organic solid an ideal and sensitive method for setting the magic angle $\Theta_m$ even at extremely high MAS rates where other methods would fail (such as the measurement of rotor 3 echoes in the 79Br NMR signal of KBr), as it does not require observation of spinning sidebands. It is worth noting that the centerband and sideband lineshapes are not dependent on magnetic field strength, with simulated spectra effectively unchanging between 7 T and 21 T (figure 16).

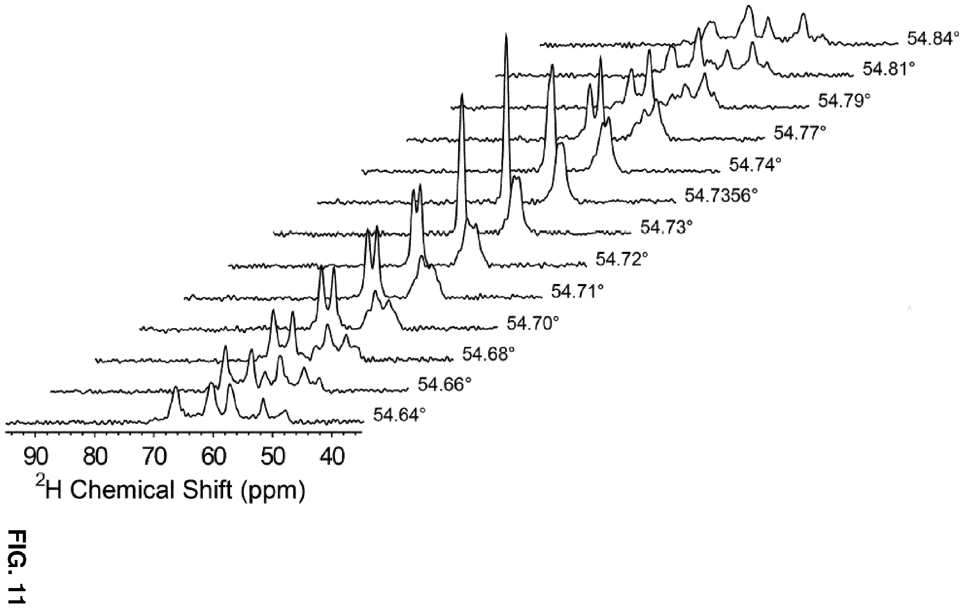

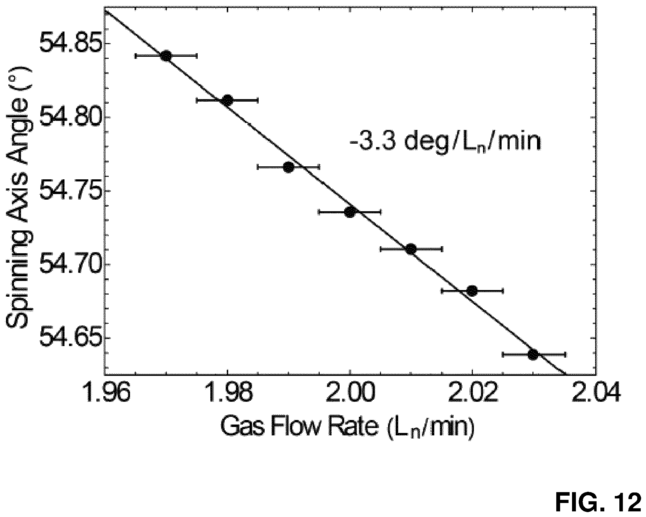

The successful implementation of the stator 1 according to the invention is further shown by the results depicted in figures 11 and 12. The gas flow rate of the adjustment device 6 was finely adjusted at values between 1.97 and 2.03 liters normal of air per minute (L$_n$/min), yielding spectra which differ in spinning angle $\Theta_s$ by 0.01° or less. The COOD resonance is the resonance at higher chemical shift (CD$_2$ is the resonance at lower chemical shift), and the angle for each spectrum was assigned based on the peak splitting for this COOD resonance using equation (1). The sensitivity of the angle adjustment capability of the stator 1 was measured by taking the linear fit of the measured flow rate values as they correspond to rotor 3 spinning axis angles $\Theta_s$, i.e. angles $\Theta_s$ between the axis of rotation R and the static magnetic field B0, resulting in a sensitivity of -3.3 $\pm$ 0.1° per L$_n$/min of flow. The needle valve used in the experimental setup was capable of restricting the flow at increments finer than the measurement precision of the digital flow meter used ($\pm$5 mL, /min), meaning that the major contribution of error to the linear fit in figure 12 was from the flow rate measurement. As predicted, a small but measurable change in the rate of rotation coincided with the change in gas flow rate, with a rate of rotation of 2861 Hz at 54.84° with 1.97 L$_n$/min of air, and a rate of 2869 Hz at 54.64° and 2.03 L$_n$/min of air. The rate of rotation was extremely stable, varying by less than $\pm 1$ Hz at each gas flow rate value of the adjustment device 6. As a result of the one-to-one relationship between rate of rotation and spinning angle $\Theta_s$, i.e. angle $\Theta_s$ between the axis of rotation R and the static magnetic field B0, due to the mechanism of the stator 1 according to the invention, use of feedback-based control (PID control) of the rate of rotation based on the optical tachometer signal also controls the angle of the axis of rotation R to a desired value. By changing properties of the fluid aperture of the adjustment device 6 such as the location within the stator cup 4, the aperture size, and the radial distance from the rotor's surface, the pneumatic angle adjustment sensitivity could be modified to suit the desired technical requirements for a given experiment.

Hence, it has been demonstrated for the first time that the angle adjustment of rotors 3 for MAS solid state NMR experiments require no mechanical adjustment to the stator 1 . It has also been affirmed that the utility of using a deuterated organic solid such as $d_4$-malonic acid represents a very precise and absolute angle measurement standard sample for solid state NMR experiments. The capability for rotors 3 to pitch within the stator 1 with no mechanical adjustment may enable the design of new probeheads 2 that utilize a monolithic RF circuit with precisely defined geometries, or may simply free up space to make smaller and more technically complex probeheads 2. Furthermore, the angle adjustment stator 1 according to the invention is capable of performing variable angle spinning (VAS) experiments from 0° to 90°, or dynamic-angle spinning (DAS, also known as switched-angle spinning or SAS) experiments, which could be made possible by rapidly gating the gas flow through the fluid aperture of the adjustment device 6.

<div align="center">LIST OF REFERENCE SIGNS</div>

| 1, 1' | stator | 23 | aperture |
|---|---|---|---|
| 2 | probe | 24 | aperture |
| 3 | rotor | 25 | surface |
| 4 | receptacle | | |
| 5 | rotation device | C | center |
| 6 | adjustment device | A | adjustment axis |
| 7 | gas inlet | CA | central axis |
| 8 | gas line | R | axis of rotation |
| 9 | exchange tube | L | longitudinal axis |
| 10 | RF coil | P | plane |
| 11 | RF coil | B0 | static magnetic field |
| 12 | fiber optics | $\Theta_m$ | magic angle |
| 13 | wave guide | $\Theta_s$ | spinning angle |
| 14 | lens | da | direction of supply |
| 15 | pivot | dr | direction of supply |
| 16 | adjuster | Da | alignment direction |
| 17 | notch | Ds | alignment direction |
| 18 | surface | fr | force of rotation device |
| 19 | chamber | fa | force of adjustment device |
| 20 | sample | ft | total force |
| 21 | fluid tube | | |
| 22 | fluid tube | | |

**Claims**

1.  A stator (1) for a probe (2) of a magnetic resonance spectrometer comprising:

    - a receptacle (4) for receiving a rotor (3), wherein the receptacle (4) is configured such, that a rotor (3) being received in the receptacle (4) is rotatable about an axis of rotation (R); and
    - at least one rotation device (5) that is configured to generate a rotation of the rotor (3) being received in the receptacle (4) about the axis of rotation (R);

    **characterized in that** the stator (1) further comprises at least one adjustment device (6) that is configured to generate a force on the rotor (3) being received in the receptacle (4) so as to adjust the axis of rotation (R) of the rotor (3) relative to an adjustment axis (A) of the stator (1).

2. The stator (1) according to claim 1, wherein the at least one adjustment device (6) is configured to adjust the axis of rotation (R) of the rotor (3) being received in the receptacle (4) and the adjustment axis (A) of the stator (1) in a non-mechanical manner, and/or
wherein the at least one adjustment device (6) is configured to adjust the axis of rotation (R) of the rotor (3) being received in the receptacle (4) and the adjustment axis (A) of the stator (1) while the stator (1) is stationary.

3. The stator (1) according to any one of the preceding claims, wherein the at least one adjustment device (6) and the at least one rotation device (5) are in each case configured to exert a force (fa; fr) on the rotor (3) such that a combination, in particular a linear combination of the force (fa) exerted by the adjustment device (6) and the force (fr) exerted by the rotation device (5) results in a total force (ft), and wherein said total force (ft) adjusts the axis of rotation (R) of the rotor (3) relative to the adjustment axis (A) of the stator (1).

4. The stator (1) according to any one of the preceding claims, wherein the at least one rotation device (5) comprises at least one fluid aperture (23) that is configured to supply a fluid to the rotor (3) and/or at least one electrical conductor that is configured to supply an electrical current to the rotor (3) and/or at least one optical source that is configured to supply electromagnetic waves to the rotor (3), and/or
wherein the at least one adjustment device (6) comprises at least one fluid aperture (24) that is configured to supply a fluid to the rotor (3) and/or at least one electrical conductor that is configured to supply an electrical current to the rotor (3) and/or at least one optical source that is configured to supply electromagnetic waves to the rotor (3).

5. The stator (1) according to any one of the preceding claims, wherein the at least one adjustment device (6) is configured to continuously adjust the axis of rotation (R) of the rotor (3) relative to the adjustment axis (A) of the stator (1), and

   i) wherein the axis of rotation (R) of the rotor (3) relative to the adjustment axis (A) of the stator (1) is preferably adjustable by changing the flow rate of the fluid and/or the potential of the electrical conductor and/or the current supplied to the electrical conductor and/or at least one of a frequency, a focus, an intensity, an energy, a number of photons or a polarization of the electromagnetic radiation being supplied by the at least one adjustment device (6), and/or
   ii) wherein the axis of rotation (R) of the rotor (3) relative to the adjustment axis (A) of the stator (1) is preferably adjustable while an action of the at least one rotation device (5) remains constant.

6. The stator (1) according to any one of the preceding claims, wherein the at least one adjustment device (6) is at least partially arranged within the receptacle (4), and/or
wherein the at least one rotation device (5) is at least partially arranged within the receptacle (4).

7. The stator (1) according to any one of the preceding claims, wherein the at least one adjustment device (6) and the at least one rotation device (5) are arranged on opposite sides or on a same side with respect to a longitudinal axis (L) of the stator (1), and/or
wherein the at least one rotation device (5) and the at least one adjustment device (6) are arranged offset with respect to one another and with respect to a longitudinal axis (L) of the stator (1) or are arranged opposite one another and with respect to the longitudinal axis of the stator (1).

8. The stator (1) according to any one of the preceding claims, wherein the receptacle (4) has a circular shape or an essentially circular shape or an at least partially circular shape, and/or
wherein the receptacle (4) is configured such as to receive a spherical rotor (3).

9. A rotor (3) configured to be received in the receptacle (4) of the stator (1) as claimed in any one of the preceding claims.

10. A probe (2) for a magnetic resonance spectrometer comprising the stator (1) as claimed in any one of claims 1 to 8 and preferably furthermore comprising the rotor (3) as claimed in claim 9.

11. A magnetic resonance spectrometer comprising the probe (2) as claimed in claim 10 or comprising the stator (1) as claimed in any one of claims 1 to 8 and preferably furthermore comprising the rotor (3) as claimed in claim 9.

12. A method of producing a stator (1) for a probe (2) of a magnetic resonance spectrometer, in particular of producing the stator (1) as claimed in any one of claims 1 to 8, the method comprising the steps of:

- Providing a receptacle (4) for receiving a rotor (3), wherein the receptacle (4) is configured such, that a rotor (3) being received in the receptacle (4) is rotatable about an axis of rotation (R);
- Providing at least one rotation device (5) that is configured to generate a rotation of the rotor (3) being received in the receptacle (4) about the axis of rotation (R);

the method being **characterized by** the further step of:

- Providing the stator (1) with at least one adjustment device (6) that is configured to generate a force on the rotor (3) being received in the receptacle (4) so as to adjust the axis of rotation (R) of the rotor (3) relative to an adjustment axis (A) of the stator (1).

13. A method of adjusting an axis of rotation (R) of a rotor (3) relative to an adjustment axis (A) of a stator (1) in a magnetic resonance spectrometer, said method comprising the steps of:

- Placing the rotor (3) into a receptacle (4) of the stator (1);
- Rotating the rotor (3) being received in the receptacle (4) about the axis of rotation (R) of the rotor (3) by at least one rotation device (5); and
- Generating a force on the rotor (3) being received in the receptacle (4) by at least one adjustment device (6) of the stator (1), whereby the axis of rotation (R) of the rotor (3) relative to the adjustment axis (A) of the stator (1) is adjusted.

14. The method as claimed in claim 13, further comprising the steps of measuring at least one magnetic resonance spectrum with the magnetic resonance spectrometer and comparing and/or correlating said at least one measured spectrum with at least one reference spectrum, and wherein the force is generated based on said comparison.

15. A computer program product comprising executable instructions stored in a non-transient computer readable medium which, when being executed by a processing unit, carry out or control the method as claimed in claim 12 or 13.

**FIG. 1**

**FIG. 2**

**FIG. 3**

1

C

6 24 22

21

5

~A;Bo;V

**FIG. 4**

Bo;V;A~

da

24;26

6

1

4 25

C

21

dr

5 23

**FIG. 5**

**FIG. 6**

**FIG. 7**

FIG. 8

FIG. 9

FIG. 10

FIG. 11

**FIG. 12**

3

1

4

**FIG. 13**

## 3000 Hz MAS

54.85°
54.80°
54.75°
54.7356°
54.70°
54.65°
54.60°

80  75  70  65  60  55  50
²H Chemical Shift (ppm)

15  10  5  0  -5  -10  -15
²H Chemical Shift (ppm)

**FIG. 14**

## 30 kHz MAS

54.85°
54.80°
54.75°
54.7356°
54.70°
54.65°
54.60°

665  660  655  650  645  640  635
²H Chemical Shift (ppm)

15  10  5  0  -5  -10  -15
²H Chemical Shift (ppm)

**FIG. 15**

## 100 kHz MAS

54.85°

54.80°

54.75°

54.7356°

54.70°

54.65°

54.60°

2180   2170   2160
²H Chemical Shift (ppm)

15  10   5   0  −5 −10 −15
²H Chemical Shift (ppm)

**FIG. 16**

## 3000 Hz MAS

### 7 T

### 21 T

54.85°

54.80°

54.75°

54.7356°

54.70°

54.65°
54.60°

3460   3000   2540
Frequency (Hz)

3460   3000   2540
Frequency (Hz)

**FIG. 17**

| | Europäisches Patentamt European Patent Office Office européen des brevets | **EUROPEAN SEARCH REPORT** | Application Number EP 21 16 4688 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2019/108754 A1 (UNIV WASHINGTON [US]) 6 June 2019 (2019-06-06) | 1-13,15 | INV. G01R33/30 |
| Y | * page 9, last paragraph; figure 8b * <br> * page 32 - paragraph 1 * | 14 | ADD. G01R33/46 |
| X | CHEN PINHUI ET AL: "Magic angle spinning spheres", SCIENCE ADVANCES, vol. 4, no. 9, 21 September 2018 (2018-09-21), page eaau1540, XP055821200, DOI: 10.1126/sciadv.aau1540 | 1-13,15 | |
| Y | * page 6, left-hand column; figures 3,4 * | 14 | |
| Y | GRIFFIN JOHN M. ET AL: "High-Resolution 19 F MAS NMR Spectroscopy: Structural Disorder and Unusual J Couplings in a Fluorinated Hydroxy-Silicate", JOURNAL OF THE AMERICAN CHEMICAL SOCIETY, vol. 132, no. 44, 19 October 2010 (2010-10-19), pages 15651-15660, XP055835898, ISSN: 0002-7863, DOI: 10.1021/ja105347q * page 15653, paragraph 1 * | 14 | |
| | | | TECHNICAL FIELDS SEARCHED (IPC) |
| | | | G01R |
| A | TOMASELLI M ET AL: "An rf-driven nuclear spin-diffusion experiment using zero-angle sample spinning", CHEMICAL PHYSICS LETTERS, ELSEVIER BV, NL, vol. 225, no. 1-3, 29 July 1994 (1994-07-29), pages 131-139, XP026489712, ISSN: 0009-2614, DOI: 10.1016/0009-2614(94)00596-6 [retrieved on 1994-07-29] * section 3 * | 1,2 | |

-/--

The present search report has been drawn up for all claims

| Place of search | Date of completion of the search | Examiner |
|---|---|---|
| Munich | 31 August 2021 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | POPP THOMAS M. OSBORN ET AL: "Pneumatic angle adjustment for magic angle spinning spherical rotors", JOURNAL OF MAGNETIC RESONANCE OPEN, vol. 6-7, June 2021 (2021-06), page 100014, XP055835893, ISSN: 2666-4410, DOI: 10.1016/j.jmro.2021.100014 * the whole document * | | |
| A | LITVAK I M ET AL: "Pneumatic switched angle spinning NMR probe with capacitively coupled double saddle coil", JOURNAL OF MAGNETIC RESONANCE, ACADEMIC PRESS, ORLANDO, FL, US, vol. 206, no. 2, 29 July 2010 (2010-07-29), pages 183-189, XP027276335, ISSN: 1090-7807 [retrieved on 2010-07-29] * the whole document * | 1-15 | |
| A | TATSUYA MATSUNAGA ET AL: "An X0 shim coil for precise magic-angle adjustment", JOURNAL OF MAGNETIC RESONANCE., vol. 256, 24 April 2015 (2015-04-24), pages 1-8, XP055290813, US ISSN: 1090-7807, DOI: 10.1016/j.jmr.2015.04.007 * page 1, left-hand column, paragraph 2 - right-hand column, paragraph 1 * | 1,2 | TECHNICAL FIELDS SEARCHED (IPC) |

The present search report has been drawn up for all claims

| Place of search | Date of completion of the search | Examiner |
|---|---|---|
| Munich | 31 August 2021 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 16 4688

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2021

| Patent document cited in search report | | Publication date | Patent family member(s) | | Publication date |
|---|---|---|---|---|---|
| WO 2019108754 | A1 | 06-06-2019 | EP | 3717924 A1 | 07-10-2020 |
| | | | US | 2021181275 A1 | 17-06-2021 |
| | | | WO | 2019108754 A1 | 06-06-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019108754 A1